# EUROPEAN PATENT APPLICATION

(11) **EP 1 246 264 A2**
(43) Date of publication of application: **02.10.2002**
(21) Application number: 02006937.3
(22) Date of filing: 26.03.2002
(51) Int. Cl.: H01L 33/00, H01S 5/323

(54) **Nitride semiconductor device**

(30) Priority: 28.03.2001 JP 2001092899
(71) Applicant: Pioneer Corporation, Meguro-ku, Tokyo (JP)
(72) Inventor: Takahashi, Hirokazu, Pioneer Corporation, Tsurugashima-shi, Saitama 350-2288 (JP); Ota, Hiroyuki, Pioneer Corporation, Tsurugashima-shi, Saitama 350-2288 (JP); Watanabe, Atsushi, Pioneer Corporation, Tsurugashima-shi, Saitama 350-2288 (JP)
(74) Representative: Manitz, Finsterwald & Partner GbR

(57) **Abstract**

A nitride semiconductor device having high electrode contact properties is disclosed. The nitride semiconductor device includes a semiconductor layer made of a group III nitride semiconductor, and a metal electrode for supplying the semiconductor layer with a carrier. The device has a first contact layer made of a group III nitride semiconductor (AlₓGa₁₋ₓ)_{1-y}In_{y}N (0≤x≤1, 0<y≤1), laminated between the semiconductor layer and the metal electrode, and a group II element added thereto, and a second contact layer made of a group III nitride semiconductor Al_{x'}Ga_{1-x'}N (0≤x'≤1) and laminated between the first contact and the metal electrode.

## Description

### BACKGROUND OF THE INVENTION

### 1. Technical Field of the Invention

The present invention relates to a group III nitride semiconductor device, and more particularly, to an improvement of the electric contact properties between a semiconductor and metal electrodes of a group III nitride semiconductor device.

### 2. Description of Related Art

In the field of light emitting devices such as light emitting diodes, semiconductor laser diodes and the like, semiconductor light emitting devices having a crystal layer of a group III nitride semiconductor (AlₓGa₁₋ₓ)_{1-y}In_{y}N (0≤x≤1, 0<y≤1) doped with a group II element such as magnesium (Mg), zinc (Zn) and the like are attracting attention as devices capable of emitting blue light. It is particularly required to develop a group III nitride semiconductor device having improved electric contact properties between electrodes and the semiconductor.

As is well known to those skilled in the art, a charge transportation on a p-type semiconductor/metal boundary basically depends on an energy difference between the valence band of the semiconductor and the Fermi level of the metal. Depending on the energy difference, an ohmic contact or a Schottky contact is formed. Presently, there is no metal which sufficiently reduces the Schottky barrier for a p-type nitride semiconductor, and further improvements in the contact properties cannot be attained by simply selecting an optimum electrode metal.

To improve the electric contact properties between electrodes and a semiconductor, a conventional method uses a semiconductor layer having a small band gap as a contact layer with a metal.

Japanese Patent Kokai No. Hei 10-65216 discloses an attempt to reduce a contact resistance with electrodes by using a nitride semiconductor including In, having a small band gap, as a contact layer with the electrodes.

A method is also known for improving the contact properties by using a semiconductor layer having a high carrier concentration for a contact layer with a metal. However, it is generally known that when the band gap is large, the foregoing method presents difficulties in achieving a high carrier density. AlGaN-based nitrides also suffer from their large band gap, and particularly with p-type ones, a high carrier concentration is difficult to achieve.

These days, it is known that a higher hole concentration is obtained as an InN mole fraction is increased in InGaN (Jpn. J. Appl, Phys. 39 (2000) 337 Kumakura et al.).

However, even a variety of methods described above have failed to obtain a semiconductor device which excels in electrode contact properties.

### OBJECT AND SUMMARY OF THE INVENTION

The present invention has been made in view of the foregoing situation, and it is an object of the invention to provide a group III nitride semiconductor device having improved electrode contact properties of the device.

A nitride semiconductor device according to one aspect of the present invention is a nitride semiconductor device including a semiconductor layer made of a group III nitride semiconductor, and a metal electrode for supplying the semiconductor layer with a carrier, the device comprising:
a first contact layer made of a group III nitride semiconductor (AlₓGa₁₋ₓ)_{1-y}In_{y}N (0≤x≤1, 0<y≤1) deposited between the semiconductor layer and the metal electrode, and a group II element added to the group III nitride semiconductor; and
a second contact layer made of a group III nitride semiconductor Alₓ,Ga₁₋ₓ,N (0≤x' ≤1) and deposited between the first contact and the metal electrode.

In the nitride semiconductor device of the present invention, the second contact layer may have a group II element added thereto.

In the nitride semiconductor device of the present invention, the second contact layer may have a thickness of 500 Å or less.

In the nitride semiconductor device of the present invention, the aforementioned group II element may be magnesium.

In the nitride semiconductor device of the present invention, the first contact layer may be In_{y}Ga_{1-y}N (0.05≤y≤0.4).

In the nitride semiconductor device of the present invention, the first contact layer characteristically may have a thickness in a range of 10 to 1000 Å.

In the nitride semiconductor device of the present invention, the nitride semiconductor device may be a light emitting device.

The present inventors have conducted detailed experiments on the electrode contact properties of a device which includes a semiconductor layer made of a group III nitride, and a metal electrode for supplying carriers, i.e., holes to the semiconductor layer, with the intention of improving the electric characteristic of the device to reach the present invention.

For example, the device disclosed in the aforementioned Japanese Patent Kokai No. Hei 10-65216 was fabricated using a contact layer made of p-type InGaN which was provided with a high hole concentration through a thermal anneal treatment, and the device was investigated for the contact properties. However, no significant improvement was achieved.

On the other hand, in the method of the present invention, after growing an InGaN layer or the like constituting a first contact layer which had Mg added thereto, a thin GaN layer or the like was grown on the topmost surface as a second contact layer, and conversion into the p-type was effected by applying the thermal anneal treatment. This process was found to improve the contact properties of the completed device.

### BRIEF DESCRIPTION OF THE DRAWINGS

Fig. 1 is a schematic cross-sectional view illustrating a semiconductor light emitting device having a multi-quantum well structure according to an embodiment of the present invention;
Fig. 2 is a schematic cross-sectional view of a substrate during a process of manufacturing the semiconductor light emitting device having a multi-quantum well structure according to the embodiment of the present invention;
Fig. 3 is a schematic cross-sectional view of a substrate during a process of manufacturing the semiconductor light emitting device according to the embodiment of the present invention;
Fig. 4 is a graph showing the electric characteristics, including the voltage and current, of the semiconductor light emitting device according to the embodiment of the present invention and devices of comparative examples; and
Fig. 5 is a schematic cross-sectional view illustrating a semiconductor light emitting device having a multi-quantum well structure according to another embodiment of the present invention.

### DETAILED DESCRIPTION OF EMBODIMENTS

In the following, a device according to the present invention will be described in connection with embodiments with reference to the accompanying drawings.

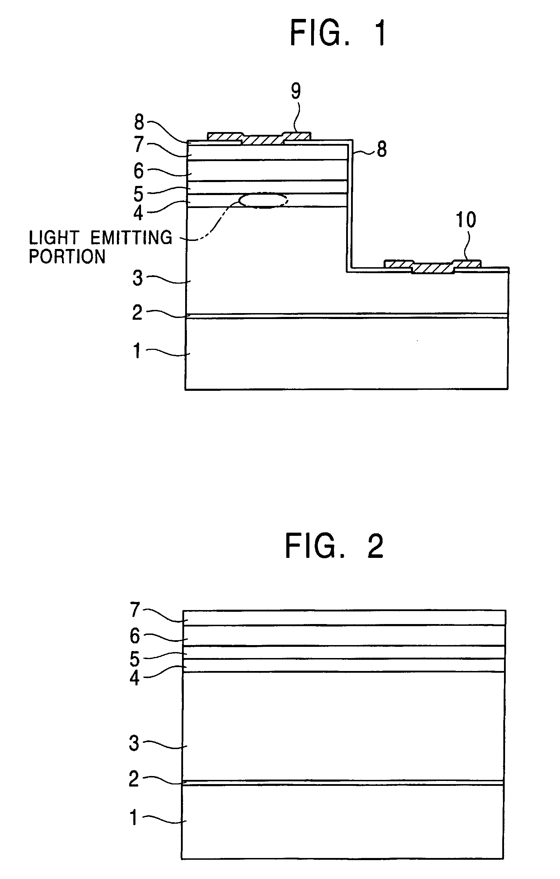

Fig. 1 illustrates a semiconductor light emitting device having a multi-quantum well structure (MQW) according to the present invention. The device comprises a multi-layer structure having a plurality of nitride semiconductor crystal films represented by (AlₓGa₁₋ₓ)_{1-y}In_{y}N (0≤x≤1, 0≤y≤1), epitaxially grown in sequence on a substrate 1 made of sapphire. On the substrate 1 made of sapphire, a low temperature buffer layer 2 made of AlN, GaN and the like, and an n-type GaN underlying layer 3 doped with Si or the like for growing a conductive layer are stacked in sequence. An active layer 4 is disposed on the n-type GaN underlying layer 3. Deposited in sequence on the active layer 4 are an Mg doped AlGaN electron barrier layer 5, an Mg doped InGaN layer 6, and an Mg-doped GaN layer 7, which are converted into the p-type through a thermal anneal treatment.

An insulating layer 8 is further deposited on the p-type Mg-doped GaN layer 7 and n-type GaN underlying layer 3, and a p-side electrode 9 and an n-side electrode 10 are formed in corresponding windows, respectively, and a light emitting device is formed of the foregoing respective portions.

In the following, detailed description will be made on a method of manufacturing the nitride semiconductor light emitting device according to the present invention.

Here, in the present invention, an organic metal vapor deposition (MOCVD) method is used as a deposition method, unless otherwise indicated. Also, a hydrogen gas is used as a gas for use in transportation of a precursor, unless otherwise indicated.

A sapphire substrate 1 is loaded into an MOCVD reactor (not shown), and an AlN buffer layer 2 is grown on the sapphire substrate at low temperatures. Then, trimethyl gallium (TMG), ammonia and methyl silane are supplied to a reactor at flow rates of 1.7 x 10⁻⁴ mol/minute, 9.0 x 10⁻² mol/minute, and 7.2 x 10⁻⁹ mol/minute, respectively, to grow an n-type GaN layer 3 doped with Si in a thickness of approximately 6 µm, at a substrate temperature of 1050°C.

Subsequently, the substrate temperature is reduced to 780°C while ammonia is being supplied to the reactor at 9.0 x 10⁻² mol/minute. Changing a precursor gas to nitrogen, In_{y1}Ga_{1-y1}N (y1=0.1) / In_{y2}Ga_{1-y2}N (y2=0.01) = 30Å/60Å is stacked five times to form an MQW active layer 4 which serves as a light emitting layer. In the growth of the In_{y1}Ga_{1-y1}N (y1=0.1) layer in the active layer 4, TMG is supplied at 4.8 x 10⁻⁶ mol/minute; trimethyl indium (TMI) at 2.6 x 10⁻⁵ mol/minute; and ammonia at 3.1 x 10⁻¹ mol/minute. In the growth of the In_{y2}Ga_{1-y2}N (y2=0.01) layer, TMG is supplied at 4.8 x 10⁻⁶ mol/minute; TMI at 2.6 x 10⁻⁶ mol/minute; and ammonia at 3.1 x 10⁻¹ mol/minute.

Subsequently, hydrogen is used as a carrier gas, the substrate temperature is increased and held at 1050°C, and TMG is supplied at 7 x 10⁻⁶ mol/minute; trimethyl aluminum (TMA) at 1.2 x 10⁻⁶ mol/minute; bisethylcyclopentadienyl magnesium (EtCp2Mg) {Mg(C₂H₅C₅H₄)₂} at 5.2 x 10⁻⁷ mol/minute; and ammonia at 2.2 x 10⁻¹ mol/minute to grow an electron barrier layer 5 made of AlₓGa₁₋ₓN (X=0.2) immediately on the active layer 4 in thickness of 0.02 µm.

Subsequently, the substrate temperature is reduced to 770°C. Changing the carrier gas to nitrogen, an Mg doped InₓGa₁₋ₓN (x=0.14) layer is grown on the electron barrier layer 5 having the thickness of 0.1 µm. Next, at the substrate temperature of 770°C, TMG is supplied at 1.0 x 10⁻⁵ mol/minute; TMI at 1.7 x 10⁻⁵ mol/minute; EtCp2Mg at 8.8 x 10⁻⁸ mol/minute; and ammonia at 4.5 x 10⁻¹ mol/minute to deposit an Mg doped InGaN layer 6. Subsequently, the supply of TMI is stopped, and the supply of EtCp2Mg is changed to 2.3 x 10⁻⁷ mol/minute to grow an Mg doped GaN layer 7, i.e., a second contact layer of 10 Å thick on the first contact layer 6, thereby completing a wafer 1 as illustrated in Fig. 2. In the growth of the final second contact layer 7 made of Mg doped GaN, the thickness is determined by epitaxially growing the second contact layer 7 for 40 seconds. The flow rate of EtCp2Mg is adjusted such that the hole concentration is maximized after thermal annealing in nitrogen, at 950°C, for 5 minutes.

To examine the electric contact properties of contacts formed on various semiconductor layers which are in contact with an electrode metal, the present inventors additionally fabricated a wafer 2 that used only Mg doped GaN, which is the material of the second contact layer 7 of the wafer 1, for constituting layers corresponding to the first contact layer 6 and second contact layer 7, i.e., the semiconductor layer between the active layer and electrode, and a wafer 3 that used only Mg doped InₓGa₁₋ₓN (X=0.14), which is the material of the contact layer 6 of the wafer 1, for constituting the corresponding portions. Among the wafers 1 to 3, the total film thicknesses of the layers between the active layer and electrode, e.g., the total thickness of GaN/InGaN (second contact layer 7/first contact layer 6) in the case of the wafer 1, are made the same with each other.

Subsequently, for converting the Mg doped semiconductor layer to a p-type semiconductor, each of the resulted wafers is thermally annealed in a nitrogen atmosphere at 950°C for 5 minutes. When a GaN-based semiconductor doped with Mg, which is a p-type dopant, is grown by an MOCVD method, this is semiinsulating when it is not at all processed, and therefore does not exhibit p-type conductivity. For this reason, after the completion of the light emitting device wafers, they are thermally annealed to activate the Mg doped layer to develop the p-type conductivity.

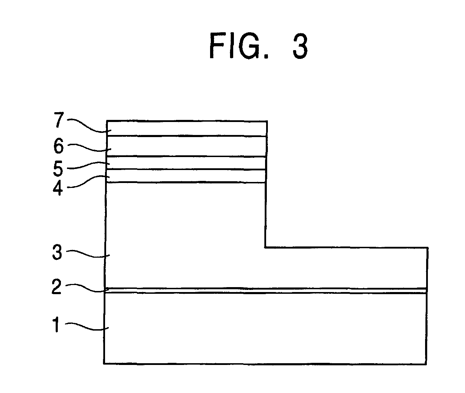

Further, the n-type GaN layer 3 is exposed, as illustrated in Fig. 3, by reactive ion etching (RIE) or the like, by way of example. Subsequently, an insulating film 8 such as SiO₂ is deposited on a partial surface of the Mg doped InₓGa₁₋ₓN (X=0.14) layer 6 or the Mg doped GaN layer 7. Next, windows are patterned on the insulating film 8 for forming electrodes. On the p-type converted Mg dope layer 6 or 7 and n-type GaN layer 3, after a semiconductor surface treatment using hydrochloric acid, a p-side electrode 9 and an n-side electrode 10 are formed, respectively, through the windows (Fig. 1). Suitable materials for the p-side electrode 9 and n-side electrode 10 are nickel and titanium, respectively.

Subsequently, the rear surface of the sapphire substrate of each wafer is polished to reduce the wafer thickness to approximately 100 µm. Then, the wafer is cleaved into chips, thereby completing devices. The devices fabricated from the wafers 1, 2, 3 are hereinafter called the device 1, device 2 and device 3, respectively.

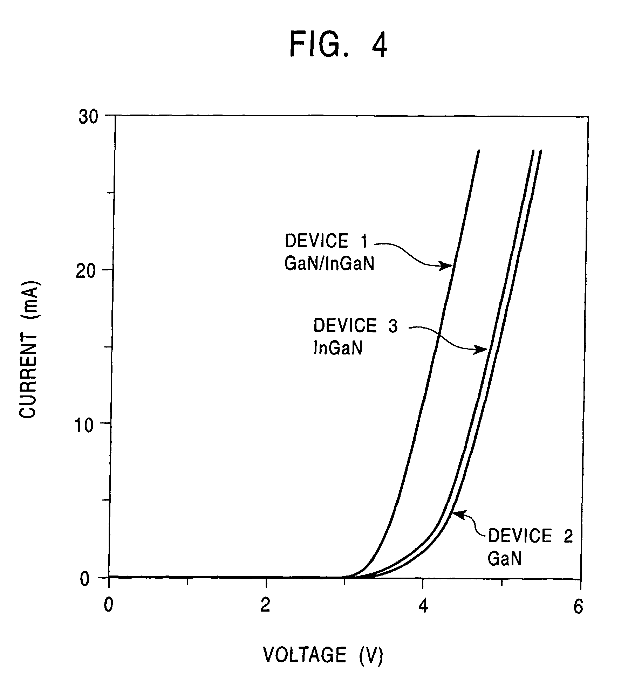

Fig. 4 shows the electric characteristics including currents and voltages of the device 1 according to the embodiment of the present invention and the comparative devices 2 and 3. As is apparent from Fig. 4, a driving voltage is reduced by the present invention.

Generally, for converting a nitride semiconductor doped with Mg into the p-type, some processing must be applied to the film, resulting in higher susceptibility of the film surface to deterioration. Particularly, in InGaN, weak coupling between In and N causes a significant deterioration. It is supposed that in the device 3, the deterioration on the InGaN surface caused by heat inhibits an expected improvement on the electric contact property.

As the second contact layer 7 made of GaN on the topmost surface is made thicker, a protective effect on InGaN is increased, but with an increased resistance value. Therefore, the thickness of the second contact layer 7 is preferably 500 Å or less.

Since the first contact layer 6 has a lattice constant different from that of the underlying layer, the crystallinity becomes lower if this layer is made excessively thick, failing to provide expected effects. Therefore, the thickness of the first contact layer 6 is preferably in a range of 10 to 1000 Å.

While the foregoing embodiment has been described for a light emitting diode to which the present invention is applied, the present invention can be applied to a laser diode in a similar manner.

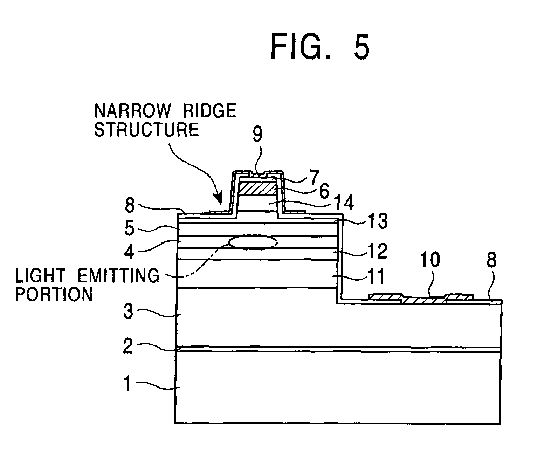

Further, as another embodiment, a ridge type semiconductor light emitting device may be formed as illustrated in Fig. 5, using the same technique as the foregoing embodiment, except that a guide layer and a cladding layer are newly provided. Specifically, an n-type AlGaN cladding layer 11 and an n-type GaN guide layer 12 are stacked between an n-type GaN underlying layer 3 and an active layer 4, and a p-type GaN guide layer 13 and a p-type AlGaN cladding layer 14 are further stacked between a p-type Mg doped AlGaN electron barrier layer 5 and a p-type first contact layer 6. In a process corresponding to the aforementioned one illustrated in Fig. 3, a mask of a predetermined width is formed on a second contact layer 7, and portions other than those below a mask, i.e., the p-type first contact layer 6, p-type second contact layer 7, and p-type AlGaN cladding layer 14 are removed, while leaving a portion of the whole thickness of the p-type GaN guide layer 13, thereby forming a narrow ridge structure. Then, an insulating film 8 is formed on the resulting wafer, a p-side electrode window in a top portion of the ridge and an n-side electrode window are formed, and respective electrodes are disposed to fabricate a ridge type semiconductor light emitting device. Members indicated by the same reference numerals in Figs. 5 and 1 are the same members. In the case of a laser diode, a larger amount of current must be injected per unit area, as compared with LED. Therefore, the effect of the present invention on reducing a required voltage for injection current, according to the present invention, is more useful in the case of the laser diode.

According to the present invention, since a group III nitride semiconductor device has a first contact layer and a second contact layer between a semiconductor active layer and a metal electrode, the electrode contact properties of the device can be improved.

## Claims

1. A nitride semiconductor device including a semiconductor layer made of a group III nitride semiconductor, and a metal electrode for supplying the semiconductor layer with a carrier, said device comprising:
a first contact layer made of a group III nitride semiconductor (AlₓGa₁₋ₓ)_{1-y}In_{y}N (0≤x≤1, 0<y≤1) deposited between said semiconductor layer and said metal electrode, with a group II element added to said group III nitride semiconductor; and
a second contact layer made of a group III nitride semiconductor Alₓ,Ga₁₋ₓ,N (0≤x'≤1) and deposited between said first contact and said metal electrode.

2. The nitride semiconductor device according to claim 1, wherein a group II element is added to said second contact layer.

3. The nitride semiconductor device according to claim 1 or 2, wherein said second contact layer has a thickness of 500 Å or less.

4. The nitride semiconductor device according to any one of claims 1 to 3, wherein said group II element is magnesium.

5. The nitride semiconductor device according to any one of claims 1 to 4, wherein said first contact layer is In_{y}Ga_{1-y}N (0.05≤y≤0.4).

6. The nitride semiconductor device according to any one of claims 1 to 5, wherein said first contact layer has a thickness in a range of 10 to 1000 Å.

7. The nitride semiconductor device according to any one of claims 1 to 6, wherein said nitride semiconductor device is a light emitting device.

8. A nitride semiconductor device according to claim 1, wherein a group II element is added at least to said second contact layer, and layers including first and second contact layers deposited on said semiconductor layer are treated by a thermal anneal treatment to develop a p-type conductivity.

9. A nitride semiconductor device according to claim 8, wherein said group II emement is mangesium.
